# EUROPEAN PATENT SPECIFICATION

(11) **EP 0 468 218 B1**
(45) Date of publication and mention of the grant of the patent: **18.09.1996**
(21) Application number: 91110607.8
(22) Date of filing: 26.06.1991
(51) Int. Cl.: H01L 27/10, G11C 11/40

(54) **Semiconductor memory device**
Halbleiterspeichereinrichtung
Dispositif de mémoire à semi-conducteur

(30) Priority: 26.06.1990 JP 168798/90
(43) Date of publication of application: 29.01.1992
(73) Proprietor: SHARP KABUSHIKI KAISHA, Osaka 545 (JP)
(72) Inventor: Shimizu, Shin, Tama-ku, Kawasaki-shi, Kanagawa-ken (JP); Iguchi, Katsuji, Yamatokoriyama-shi, Nara-ken (JP); Kakimoto, Seizo, Shiki-gun, Nara-ken (JP); Doi, Tsukasa, 22-301 Nishiyamato-Kataokadai-danchi, Kitakatsuragi-gun, Nara-ken (JP)
(74) Representative: TER MEER - MÜLLER - STEINMEISTER & PARTNER

(56) References cited:
- EP-A- 0 045 578
- EP-A- 0 051 158
- EP-A- 0 223 616
- EP-A- 0 337 436
- US-A- 4 462 090
- US-A- 4 900 690

## Description

### BACKGROUND OF THE INVENTION

### 1. Field of the Invention:

This invention relates to a highly integrated and large-capacity semiconductor memory device which includes MOS (metal-oxide-semiconductor) transistors.

### 2. Description of the Prior Art:

Figure 9 shows a memory cell portion of a conventional semiconductor memory device including MOS transistors. The memory device has a semiconductor substrate **70** on which a rectangular active region **72** is formed by an LOCOS isolation method (local oxidation method) or by a trench isolation method. Gate electrodes **73** and **74** are formed from polysilicon in such a manner as to intersect the active region **72**. Portions of the active region **72** positioned under the gate electrodes **73** and **74** function as channel regions **82** and **81**, respectively. A drain region **76** is formed in a portion of the active region **72** interposed between the gate electrodes **73** and **74**. In the other portions of the active region **72** are formed source regions **75** and **77**, which are positioned adjacent to the gate electrodes **73** and **74**, respectively.

The gate electrode **73**, channel region **82**, source region **75** and drain region **76** constitute an MOS transistor, while the gate electrode **74**, channel region **81**, source region **77** and drain region **76** constitute another MOS transistor. The two MOS transistors have the drain region **76** in common.

The drain region **76** is connected to a bit line (not shown) through a bit contact **79**. The source regions **75** and **77** are connected to one of the electrodes of a charge storage capacitor (not shown) through storage contacts **78** and **80**, respectively.

The above-described two MOS transistors, bit contact **79**, storage contacts **78** and **80**, and charge storage capacitor constitute a memory cell of the semiconductor memory device. The gate electrodes **73** and **74** function as word lines through which address signals are fed into the memory cell.

In cases where a memory cell such as described above has n-type MOS transistors, the application of a high potential bias to the gate electrode **73** or **74** allows one of the two MOS transistors to be in the on state. At this time, if the memory cell is in the read state, a signal charge stored in the capacitor is transmitted into the drain region **76** through the storage contact **78** or **80**, source region **75** or **77** and channel region **82** or **81** of the MOS transistor in the on state. The signal charge is then sent to a sense amplifier (not shown) through the bit contact **79** and the bit line. Conversely, if the memory cell is in the write state, a signal charge is transmitted from the drain region **76** in the reverse direction through the above-mentioned components into the capacitor, where the signal charge is stored.

In the production of MOS transistors of such a memory cell, impurity ions are implanted into an active region to form source and drain regions while providing ohmic contacts between the resulting regions and the electrode material. The impurity ions are usually implanted into, for example, the entire area (impurity-implanted region 71 as shown in Figure 9) of the MOS transistors. The gate electrodes 73 and 74 function as a mask for the ion implantation, so that the impurity ions can be implanted into the areas corresponding to tho source and drain regions to be formed. In this case, a portion of the active region on the drain side becomes the drain region 76, and portions of the active region on the source sides become the source regions 75 and 77.

Most of conventional DRAMs (dynamic random access memories) which are known as semiconductor memory devices have folded bit lines in order to attain high resistance to noise. Thus, when the active regions are rectangular as shown in Figure 9, the respective memory cells are arranged as shown in Figure 10. As shown in the figure, active regions 89, 90, 92 and 93 are disposed close to the active region 91. The active regions are arranged in columns parallel to gate electrodes 96 functioning as word lines. The active regions in one column are shifted from those in the columns adjacent thereto half the pitch of the active regions in each column. For example, as shown in the figure, the active regions 88 and 91 are respectively shifted from the active regions 89 and 92, and also from the active regions 90 and 93, by half the pitch, i.e., by half of the distance between the active regions 88 and 91.

For the formation of an isolation region which electrically isolates one active region from another, a silicon substrate is locally oxidized using the LOCOS isolation method in the production of 4-megabit DRAMs (4M DRAMs) or other memory devices with a relatively low integration level. On the other hand, in the production of 16M DRAMs and 64M DRAMs which are highly integrated memory devices with minute structures, it is necessary to form a narrow isolation region with a width of 0.6 to 0.7 µm and with a width of 0.4 to 0.5 µm, respectively. However, an isolation region with a width of 0.4 to 0.7 µm cannot be formed by the use of the LOCOS isolation method. Thus, for the production of highly integrated memory devices which require a narrow isolation region, the trench isolation method should be used to form the isolation region.

A conventional semiconductor memory device such as described above has the following problems:
1) As shown in Figure 9, the impurity-implanted region **71** overlaps with the entire surface of the MOS transistors. Thus, during the subsequent heat treatment in the formation of the minute structure of memory cells, the impurity ions previously implanted into the impurity-implanted region **71** will be diffused by heat from the source regions **77** and **75** and the drain region **76** into the channel regions **81** and **82**, through the entire boundaries between the channel region **81** and the source region **77** and drain region **76** and also through the entire boundaries between the channel region **82** and the source region **75** and drain region **76**.
   This causes a noticeable short channel effect such as a reduced threshold voltage and a reduced punch through breakdown voltage, thereby increasing leakage current, particularly in an MOS transistor which is the smallest transistor unit used for the memory cell of DRAMs. As a result, it becomes difficult for the capacitor to store signal charges in the storage operation of the memory cells.
2) Since the impurity-implanted region **71** overlaps with the entire surface of the MOS transistors as described above, the total area of the source regions **75** and **77** and drain region **76** becomes relatively large. Thus, the junction capacitance which arises between the silicon substrate **70** and the source and drain regions **77**, **75** and **76** increases. In particular, the parasitic capacitance of the bit lines increases, thereby increasing the power consumption and reducing the operation speed.
3) As shown in Figure 10, in memory devices having folded bit lines, the distances between the active region **91** and the active regions **89**, **90**, **92** and **93** are half or less of that between the active region **91** and the active region **88**. Accordingly, the isolation region to be formed is uneven in width between the respective active regions. It is, however, extremely difficult to form an isolation region with an uneven width by the trench isolation method. Thus, the production of highly-integrated 16M DRAMs or 64M DRAMs requires two isolation methods; i.e., the LOCOS isolation method which enables the formation of an isolation region with an uneven width, and the trench isolation method which enables the formation of a narrow isolation region with a width of 0.4 to 0.7 µm. The use of the two methods causes a complicated production process.

US-A-4 900 690 discloses a MOS-FET semiconductor device comprising an active region with source and drain diffusions in source-side and drain-side active regions adjacent to both sides of a channel region. The source diffusion and drain diffusion each extends over the whole source-side or drain-side active region. This document contains also the wording that "the source and drain diffusions are defined in a part of the active region" which wording could give the impression as if the source diffusion and drain diffusion each could extend over a part of the source-side or drain-side active region. From the complete teaching of said document, however, it is clear that this would be a misinterpretation because source and drain diffusions are part of the active region in the sense that they share the active region with the channel region.

### SUMMARY OF THE INVENTION

The semiconductor memory device of this invention, which overcomes the above-discussed and numerous other disadvantages and deficiencies of the prior art, comprises a plurality of memory cells each of which comprises
an MOS transistor including a source region, a drain region and a channel region;
an active region including said source region, said drain region and said channel region of said MOS transistor, said active region being formed in the surface portion of a semiconductor substrate;
an isolation region formed in the surface portion of said semiconductor substrate, said isolation region surrounding said active region, thereby forming a boundary between said isolation region and said active region;
a gate electrode formed on the substrate for the MOS transistor in the active region so as to divide the active region into a source-side active region with a storage contact and a drain-side active region with a bit contact, the portion of said active region which is positioned under the gate electrode functioning as said channel region of the MOS transistor
a first impurity-implanted region formed in a part of said source-side active region so as to overlap with at least one part of said storage contact and the gate electrode, a portion of the source-side active region which overlaps with the first impurity-implanted region functioning as said source region of the MOS transistor; and
a second impurity-implanted region formed in a part of said drain-side active region so as to overlap with at least one part of said bit contact and the gate electrode, a portion of the drain-side active region which overlaps with the second impurity-implanted region functioning as said drain region of the MOS transistor (claim 1).

Depending claims 2 to 6 are respectively specifying advantageous developments thereof.

In a preferred embodiment, the active regions in the memory cells are disposed in columns parallel to the gate electrode, and the active regions in two adjacent rows are staggered to each other so that all the distances between adjacent active regions are approximately equal to each other.

In a preferred embodiment, the active region is T-shaped.

In another preferred embodiment, the active region is Y-shaped.

In still another preferred embodiment, the active region is V-shaped.

In a further preferred embodiment, the active region is set diagonally across the gate electrode.

Thus, the invention described herein makes possible the objectives of (1) providing a semiconductor memory device which has a significantly reduced short channel effect to assure high reliability in the storage operation; (2) providing a semiconductor memory device which has a significantly reduced junction capacitance to provide high-speed operation with less power consumption; and (3) providing a semiconductor memory device having an isolation region which can readily be formed by a simple process.

### BRIEF DESCRIPTION OF THE DRAWINGS

This invention may be better understood and its numerous objects and advantages will become apparent to those skilled in the art by reference to the accompanying drawings as follows:

Figure 1 is a plan view showing a semiconductor memory device of this invention.

Figure 2 is an enlarged view showing an active region of the semiconductor memory device of Figure 1.

Figures 3a to 3d are sectional views of the semiconductor memory device taken along lines A-A', B-B', C-C' and D-D' of Figure 2, respectively.

Figure 4 is a plan view showing another semiconductor memory device of this invention.

Figure 5 is a plan view showing an active region of still another semiconductor memory device according to this invention.

Figure 6 is a plan view showing an active region of a modified version of the semiconductor memory device of Figure 5.

Figure 7 is a plan view showing another modified version of the semiconductor memory device of Figure 5.

Figure 8 is a plan view showing a further semiconductor memory device of this invention.

Figure 9 is an enlarged view showing a memory cell portion of a conventional semiconductor memory device.

Figure 10 is a plan view of the conventional semiconductor memory device of Figure 9.

### DESCRIPTION OF THE PREFERRED EMBODIMENTS

The semiconductor memory device of this invention has a plurality of T-shaped or Y-shaped active regions including MOS transistors on a semiconductor substrate. The T-shaped or Y-shaped active regions are arranged in columns in such a manner that the active regions in two adjacent rows are shifted from each other to allow all the distances between adjacent active regions to be substantially equal. The formation of the isolation region does not require the LOCOS isolation method which enables the formation of an isolation region with an uneven width, but requires only the trench isolation method which enables the formation of a narrow isolation region. Thus, in the production of the memory device of the present invention, the isolation region can readily be formed by a simple process.

In the semiconductor memory device of this invention, an impurity-implanted region for the formation of a source region overlaps with only part of the active region on the source side and also overlaps with part of a contact area of the source-side active region. Similarly, an impurity-implanted region for the formation of a drain region overlaps with only part of the active region on the drain side and also overlaps with part of a contact area of the drain-side active region.

When impurity ions are implanted into the above-described impurity-implanted regions, a portion of the source-side active region overlapping with the impurity-implanted region becomes a source region, while a portion of the drain-side active region overlapping with the impurity-implanted region becomes a drain region. Thus, in the heat treatment to be performed after the ion implantation, the injected impurity ions are diffused from the source and drain regions into a channel region through only a portion of each boundary between the channel region and the source-side and drain-side active regions. This prevents the effective channel length from becoming shorter, thereby significantly reducing the short channel effect.

Furthermore, the total area of the source and drain regions can be significantly reduced, as compared with a conventional semiconductor memory device having an impurity-implanted region which overlaps with the entire area of the memory cell. The reduction in the area of the source and drain regions decreases the junction capacitance between the semiconductor substrate and the source and drain regions. Therefore, the parasitic capacitance of the semiconductor memory device can be reduced, which assures high reliability in the storage operation of the memory device.

According to the present invention, active regions may be in other forms, e.g., they may be V-shaped or may be set diagonally across gate electrodes. In these cases. the impurity-implanted regions for the formation of source and drain regions overlap with only part of the source-side and drain-side active regions, so that the above-described advantages such as a reduced short channel effect and a reduced junction capacitance can also be attained.

The invention will be further described by reference to the following examples.

### Example 1

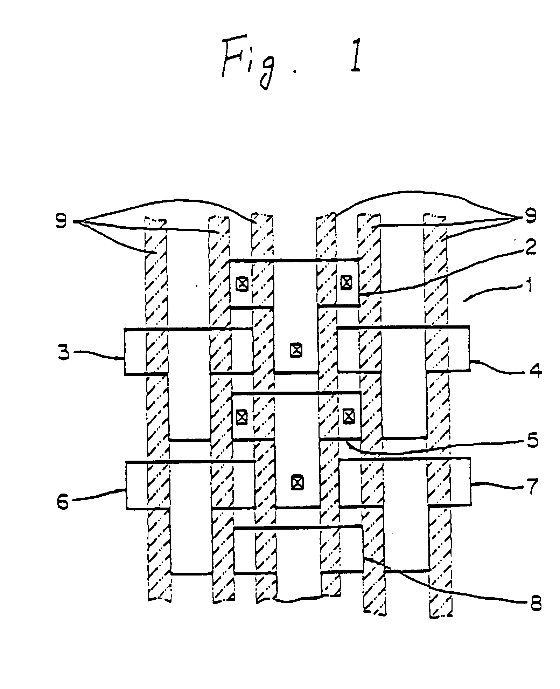

Figure 1 shows a semiconductor memory device according to this invention. The semiconductor memory device of this example includes a semiconductor substrate I with T-shaped active regions 2, 3, 4, 5, 6, 7 and 8 formed in the surface portion thereof. Gate electrodes 9 are formed on the semiconductor substrate 1. The active regions 2 to 8 are arranged in a manner based on the folded bit line system. The downward extending portion of each of the T-shaped active regions 2 to 8 is interposed between the two adjacent gate electrodes 9.

The active regions 2 to 8 are arranged in columns parallel to the gate electrodes 9. The active regions in two adjacent rows are staggered to each other, e.g., the active regions 2, 5 and 8 alternate with the active regions 3 and 6, and also with the active regions 4 and 7, so that all the distances between the two adjacent active regions are approximately equal. Thus, an isolation region which electrically isolates one active region from another can be formed with a uniform width. This eliminates the necessity of using the LOCOS isolation method which enables the formation of isolation regions with an uneven width. Therefore, even in the production of a highly integrated semiconductor memory device which requires a narrow isolation region, it is not necessary to use a complicated process which includes both the LOCOS isolation method and the trench isolation method for the formation of the isolation region. The isolation region can be formed using only the trench isolation method which is useful in the formation of a narrow isolation region. In the production of the semiconductor memory device of this example, the isolation region can readily be formed by a simple process, as compared with cases where all the distances between adjacent active regions are not equal.

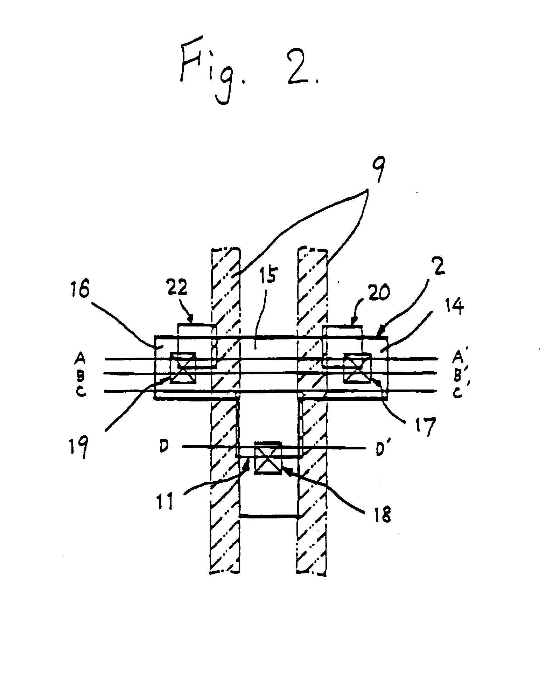

Figure 2 is an enlarged view showing the active region **2** of Figure 1. The active region **2** and the two gate electrodes **9** which intersect the active region **2** constitute a pair of MOS transistors. Portions of the active region **2** which are positioned under the gate electrodes **9** function as channel regions. The active region **2** has regions **14** and **16** on the source side (i.e., source-side active regions **14** and **16**) and also has a region **15** on the drain side (i.e., drain-side active region **15**). Storage contacts **17** and **19** which function as contact areas are disposed on the source-side active regions **14** and **16**, respectively. A bit contact **18** which also functions as a contact area is disposed on the drain-side active region **15**.

The MOS transistors are also provided with impurity-implanted regions **20** and **22** for the source-side active regions **14** and **16**, respectively, and with an impurity-implanted region **11** for the drain-side active region **15**. The impurity-implanted region **20** overlaps with part of the source-side active region **14** and part of the storage contact **17**. The impurity-implanted region **22** overlaps with part of the source-side active region **16** and part of the storage contact **19**. The impurity-implanted region **11** overlaps with part of the drain-side active region **15** and part of the bit contact **18**. Impurity ions are implanted into these impurity-implanted regions **20**, **22** and **11** to form source and drain regions. Portions of the source-side active regions **14** and **16** which respectively overlap with the impurity-implanted regions **20** and **22** become source regions. Similarly, a portion of the drain-side active region **15** which overlaps with the impurity-implanted region **11** becomes a drain region.

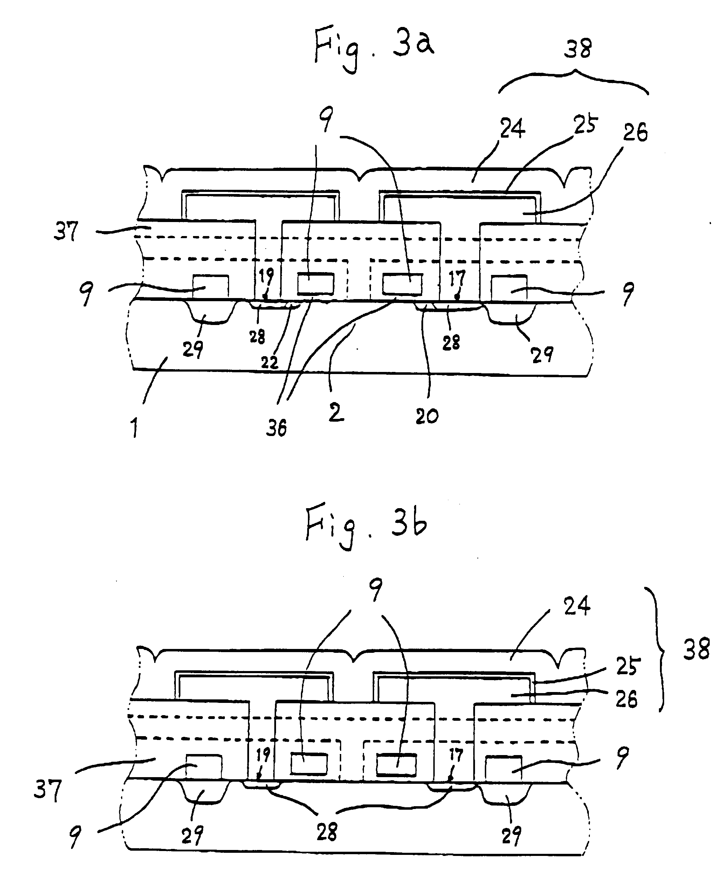

Figure 3a is a sectional view of the semiconductor memory device taken along line A-A' of Figure 2. In Figure 3a, two other gate electrodes **9** are also shown which are respectively adjacent to the gate electrodes **9** of Figure 2. The gate electrodes **9** shown in Figure 2 are formed above the active region **2** with gate insulators **36** interposed therebetween. The other gate electrodes **9** are formed on the isolation region **29**. Interlayer insulators **37** are formed on all the gate electrodes **9** and on the substrate **1**, while some portions of the active region **2** remain uncovered.

The semiconductor memory device further includes capacitors 38 each having an upper plate electrode **24** and a lower plate electrode **26** with a capacitor dielectric film **25** interposed therebetween. The upper plate electrode **24** is common to all the capacitors **38**. The lower plate electrodes **26** are formed on the interlayer insulators **37** and also on the portions of the active region **2** which are not covered with the interlayer insulators **37**. The interfaces between the active region **2** and the lower plate electrodes **26** function as the storage contacts **17** and **19**. The impurity-implanted regions **20** and **22** for the formation of the source regions are located in the surface portion of the substrate **1**. As shown in this figure, the storage contacts **17** and **19** are provided on part of the impurity-implanted region **20** and part of the impurity-implanted region **22**, respectively. In the impurity-implanted regions **20** and **22**, n-type diffusion regions **28** are formed by impurity diffusion from the storage contacts **17** and **19**, respectively.

The n-type diffusion region **28** may be spaced apart from the isolation region **29**, as shown in Figure 3a. On the other hand, the storage contact **17** shown in this figure is wider than each gate electrode **9**, in which case the n-type diffusion region **28** on the right in this figure is in contact with the isolation region **29**.

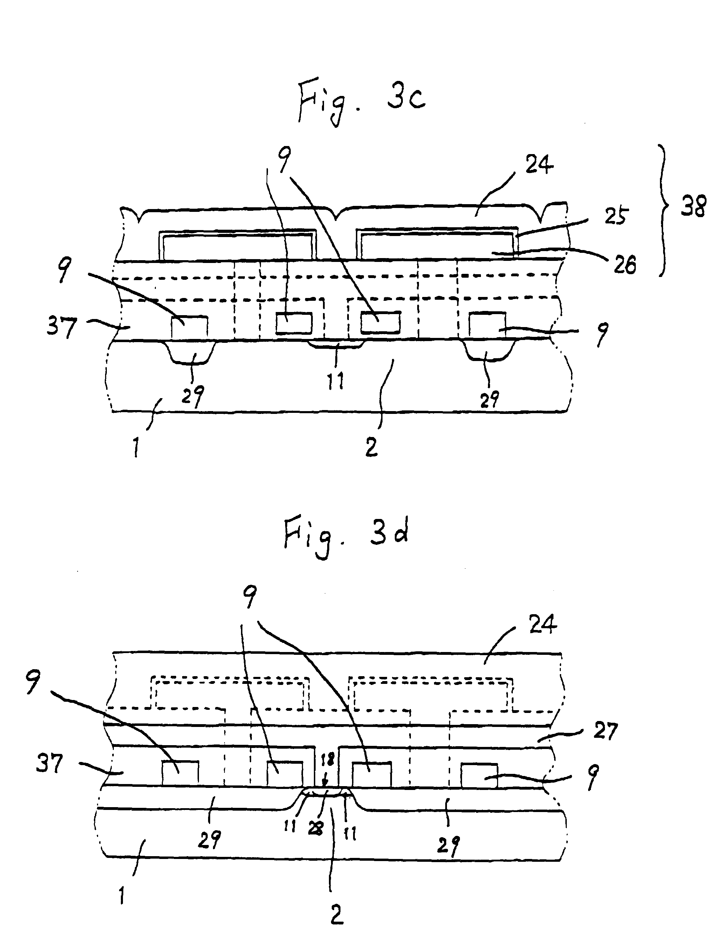

Figures 3b, 3c and 3d are sectional views of the semiconductor memory device taken along lines B-B', C-C' and D-D' of Figure 2, respectively. No impurity-implanted region **20**, **22** or **11** can be seen in Figure 3b. The impurity-implanted region **11** for the formation of the drain region is shown in Figures 3c and 3d. As shown in the figures, the impurity-implanted region **11** is located in the surface portion of the substrate **1**.

In Figure 3d, all the gate electrodes **9** are located on the isolation region **29**. A portion of the active region **2** which is not covered with the interlayer insulators **37** is in contact with a bit line **27**. The interface between the bit line **27** and the active region **2** functions as the bit contact **18**. In the impurity-implanted region **11**, an n-type diffusion region **28** is also formed by impurity diffusion from the bit contact **18**.

Since each impurity-implanted region **20** or **22** only overlaps with part of the corresponding source-side active region **14** or **16**, the resultant source region occupies only part of the corresponding source-side active region **14** or **16**. Also, the boundary between the source region and the channel region adjacent thereto occupies only a portion of the entire boundary between the corresponding source-side active region **14** or **16** and the channel region adjacent thereto. Similarly, the drain region occupies only part of the drain-side active region **15**, and the boundary between the drain region and each channel region adjacent thereto also occupies only a portion of the entire boundary between the drain-side active region **15** and each channel region adjacent thereto.

In the memory device of this example shown in Figures 1, 2 and 3a to 3d, each MOS transistor has an independent impurity-implanted region 20 or 22 for the corresponding source-side active region 14 or 16. According to the present invention, however, two adjacent source-side active regions belonging to different MOS transistors may have a single impurity-implanted region in common. Alternatively, such two adjacent source-side active regions and a drain-side active region positioned therebetween may have a single impurity-implanted region in common.

### Example 2

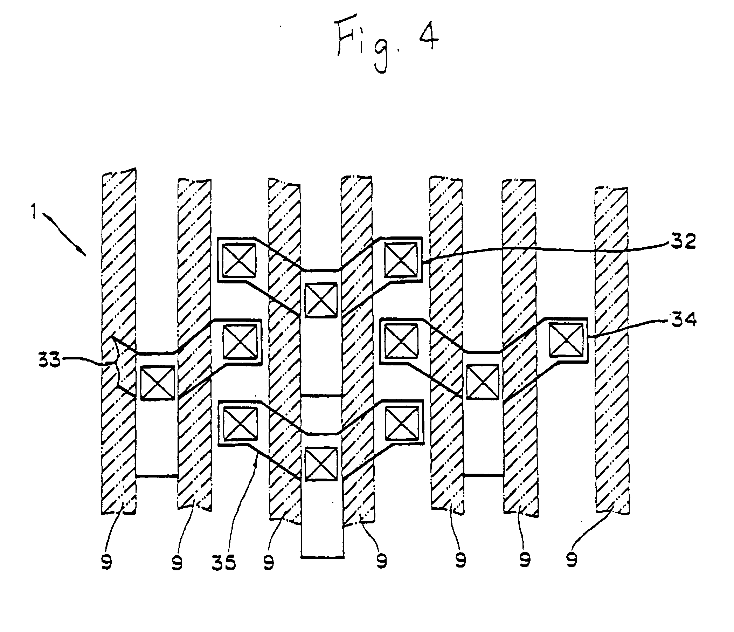

Figure 4 shows another semiconductor memory device according to the invention. The memory device of this example is produced in substantially the same manner as the device of Figures 1, 2 and 3a to 3d, except that the active regions are Y-shaped instead of being T-shaped. Thus, the same reference numerals represent the same components in Figures 1 through 4.

As shown in Figure 4, the semiconductor memory device includes the semiconductor substrate 1 with Y-shaped active regions 32, 33, 34 and 35 formed in the surface portion thereof. Gate electrodes 9 are formed on the semiconductor substrate 1. The active regions 32 to 35 are arranged in a manner based on the folded bit line system. The downward extending portion of each of the Y-shaped active regions 32 to 35 is interposed between the two adjacent gate electrodes 9.

In the same manner as in the memory device of Figure 1, the active regions 32 to 35 are arranged in columns parallel to the gate electrodes 9. The active regions in two adjacent columns are alternately arranged, so that all the distances between the two adjacent active regions are approximately equal. For example, the active regions in the column including the active regions 32 and 35 alternate with those in the column including the active region 33 and also with those in the row including the active region 34. Thus, also in this example, since the isolation region to be formed has a uniform width, it is not necessary to use the combination of the LOCOS isolation method and the trench isolation method for the formation of the isolation region. The isolation region can be formed only by the use of the trench isolation method which is useful in the formation of a narrow isolation region.

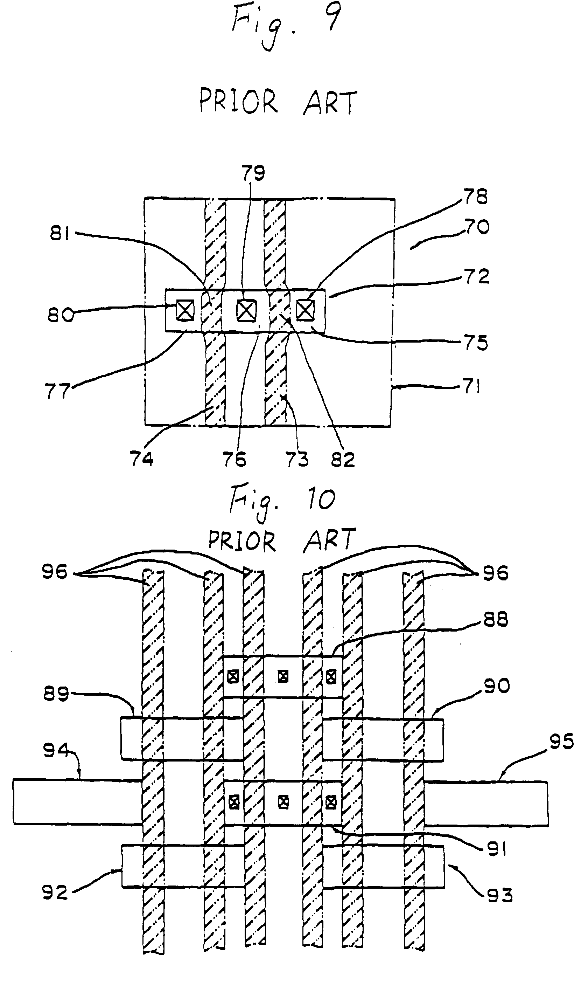

In the memory device of this example, each MOS transistor may have its own impurity-implanted region in the same manner as in the memory device shown in Figure 2. Alternatively, adjacent MOS transistors may have an impurity-implanted region in common in the same manner as in the memory device shown in Figure 7 which will be described later.

### Example 3

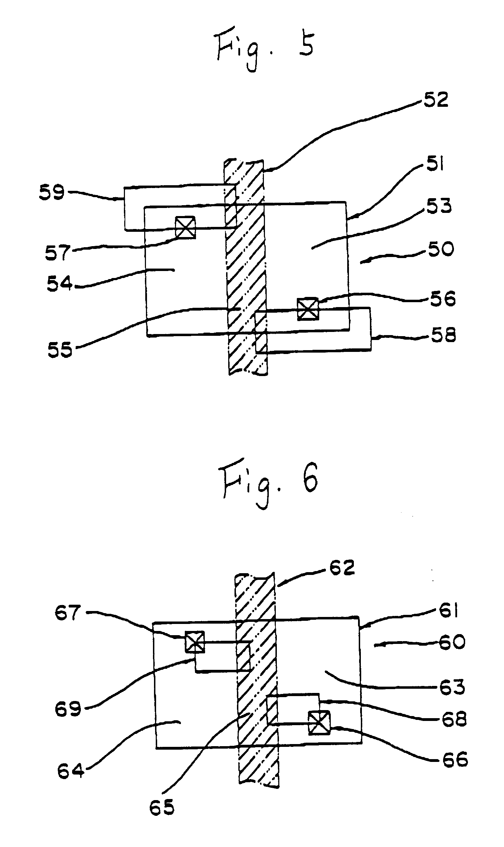

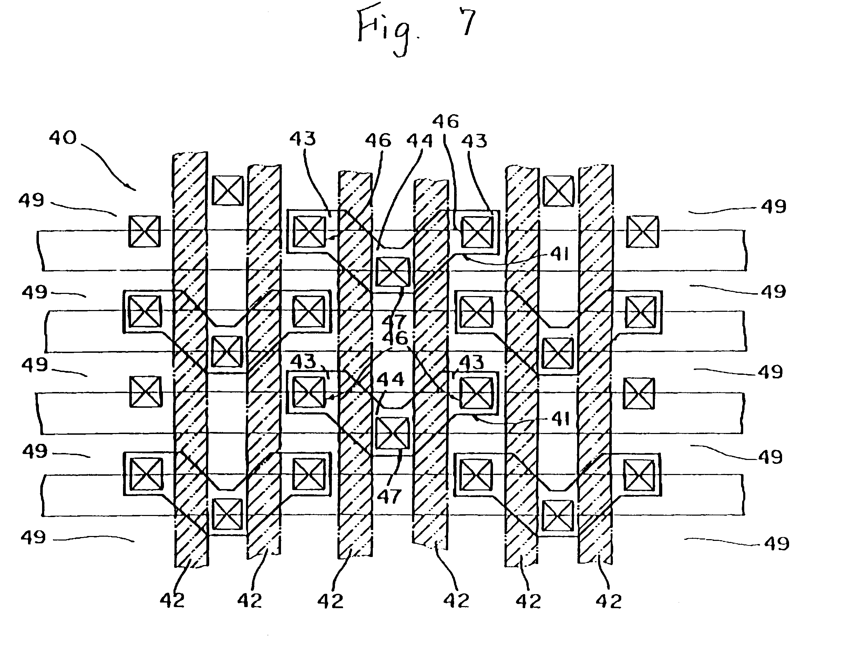

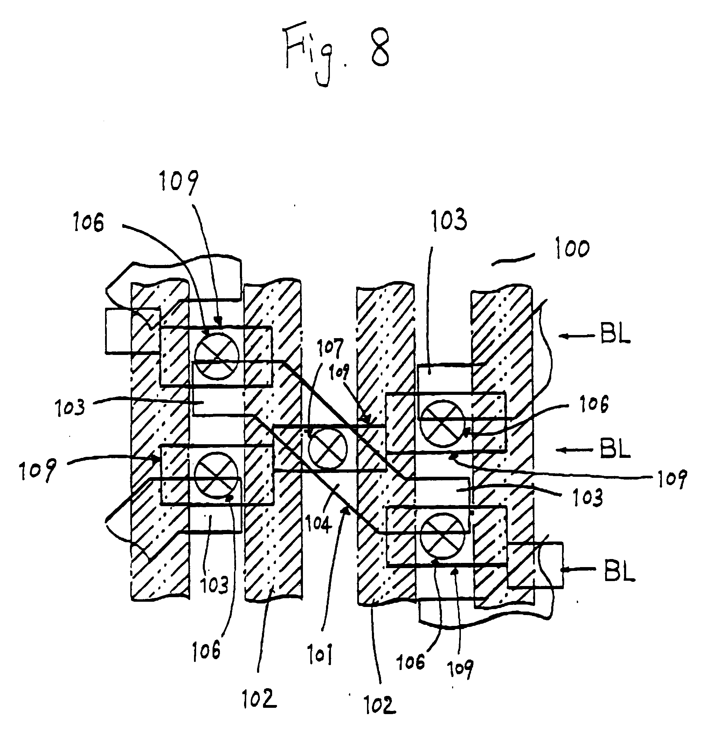

Figure 5 shows still another semiconductor memory device according to the invention. The memory device of this example has a semiconductor substrate 50 with an active region 51 formed in the surface portion thereof. A gate electrode 52 is formed on the semiconductor substrate 50. The active region 51 includes a source-side active regicn 53 and a drain-side active region 54 which are provided with contact areas 56 and 57, respectively. The contact areas 56 and 57 are shifted in position from each other along a direction parallel to the gate electrode **52**. The portion of the active region **51** positioned under the gate electrode **55** functions as a channel region. The gate electrode **52** and the active region **51** constitute an MOS transistor.

The memory device of this example is also provided with impurity-implanted regions **58** and **59** into which impurity ions are implanted to form source and drain regions. The impurity-implanted region **58** overlaps with part of the source-side active region **53** and part of the contact area **56**, and the impurity-implanted region **59** overlaps with part of the drain-side active region **54** and part of the contact area **57**. Thus, the resultant source region occupies only part of the source-side active region **53**. The boundary between the source region and the channel region occupies only a portion of the boundary between the source-side active region **53** and the channel region. Similarly, the drain region occupies only part of the drain-side active region **54**, and the boundary between the drain region and the channel region occupies only a portion of the boundary between the drain-side active region **54** and the channel region.

In the memory device of Figure 5, both the impurity-implanted regions **58** and **59** are partly located outside the active region **51**. According to the present invention, however, the impurity-implanted regions may be entirely located inside the active region in the same manner as in a semiconductor memory device shown in Figure 6 which is a modified version of the memory device of Figure 5. In Figure 6, the impurity-implanted regions are denoted by the reference numerals **68** and **69**. Except for the location of the impurity regions, the memory device of Figure 6 is produced in the same manner as that of Figure 5.

### Example 4

Figure 7 shows still another modified version of the semiconductor memory device of Figure 5. This memory device includes a semiconductor substrate **40** with V-shaped active regions **41** formed in the surface portion thereof. Gate electrodes **42** are formed on the semiconductor substrate **40**. Each of the active regions **41** includes two source-side active regions **43** and a drain-side active region **44**. Each source-side active region **43** and each drain-side active region **44** have contact areas **46** and **47**, respectively. The portions of each active region **41** positioned under the gate electrodes **42** function as channel regions. Each active region **41** and the two gate electrodes **42** intersecting the active region **41** constitute two MOS transistors.

Impurity-implanted regions **49** overlap with part of each source-side active region **43**, part of each contact area **46**, part of each drain-side active region **44**, and part of each contact area **47**. Impurity ions are implanted into the impurity-implanted regions **49** to form source and drain regions. The source regions are formed in the portions of the source-side active regions **43** overlapping with the impurity-implanted regions **49**, and the drain regions are formed in the portions of the drain-side active regions **44** overlapping with the impurity-implanted regions **49**.

Since the impurity-implanted regions **49** overlap with only part of each source-side active region **43**, each of the resultant source regions occupies only part of the corresponding source-side active region **43**. Also, the boundary between the source region and the channel region adjacent thereto occupies only a portion of the boundary between the source-side active region **43** and the channel region. Similarly, each of the drain regions occupies only part of the corresponding drain-side active region **44**, and the boundary between the drain region and each channel region adjacent thereto also occupies only a portion of the entire boundary between the drain-side active region **44** and each channel region adjacent thereto.

### Example 5

Figure 8 shows a further semiconductor memory device according to this invention. This memory device includes a semiconductor substrate **100** with diagonal active regions **101** formed in the surface portion thereof. Gate electrodes **102** are formed on the semiconductor substrate **100**. As can be seen from the figure, the diagonal active regions **101** are set diagonally across the gate electrodes **102**. Each of the active regions **101** includes two source-side active regions **103** and a drain-side active region **104**. Each source-side active region **103** and each drain-side active region **104** have contact areas **106** and **107**, respectively. The portions of each active region **101** positioned under the gate electrodes **102** function as channel regions. Each diagonal active region **101** and the two gate electrodes **102** intersecting the active region **101** constitute two MOS transistors. Bit lines are to be disposed in the areas denoted by **BL**.

Impurity-implanted regions **109** overlap with part of each source-side active region **103**, part of each contact area **106**, part of each drain-side active region **104**, and the entire area of each contact area **107**. Impurity ions are implanted into the impurity-implanted regions **109** to form source and drain regions. The source regions are formed in the portions of the source-side active regions **103** overlapping with the impurity-implanted regions **109**, and the drain regions are formed in the portions of the drain-side active regions **104** overlapping with the impurity-implanted regions **109**.

Since the impurity-implanted regions **109** overlap with only part of each source-side active region **103**, each of the resultant source regions occupies only part of the corresponding source-side active region **103**. Also, the boundary between the source region and the channel region adjacent thereto occupies only a portion of the boundary between the source-side active region **103** and the channel region. Similarly, each of the drain regions occupies only part of the corresponding drain-side active region **104**, and the boundary between the drain region and each channel region adjacent thereto also occupies only a portion of the entire boundary between the drain-side active region **104** and each channel region adjacent thereto.

As described above, in all the foregoing examples shown in Figures 1 through 8, the boundary between each channel region and the source region adjacent thereto occupies only a portion of the entire boundary between the channel region and the source-side active region adjacent thereto. Similarly, the boundary between each channel region and the drain region adjacent thereto occupies only a portion of the entire boundary between the channel region and the drain-side active region adjacent thereto. Thus, in a heat treatment process or the like to be performed after the ion implantation, the injected impurity ions are diffused by heat from the source and drain regions into the channel regions only through the above-mentioned portions of the boundaries between the channel regions and the source-side and drain-side active regions. Thus, the effective channel lengths do not become significantly shorter. Even in a memory device according to a fine design rule, the short channel effect can be significantly reduced. This assures high reliability in the storage operation of the semiconductor memory device.

Also in all the semiconductor memory devices of Figures 1 through 8, only part of each source-side active region and part of each drain-side active region overlap with the respective impurity-implanted regions, so that the total area of the resultant source and drain regions is reduced, as compared with the case where impurity-implanted regions overlap with the entire source-side and drain-side active regions. Thus, junction capacitance which arises between the semiconductor substrate and the source and drain regions can be reduced. The reduction in the junction capacitance decreases the parasitic capacitance of the semiconductor memory device.

According to the present invention, since the impurity-implanted regions overlap with only part of each source-side active region and part of each drain side-active region, it is possible to attain two excellent advantages, i.e., the reduction in the short channel effect and in the junction capacitance as described above. These two advantages are particularly noticeable in an LDD (Lightly Doped Drain) process where N⁺ (high-concentration) ion implantation is not performed but N⁻ (low-concentration) ion implantation alone is performed.

## Claims

1. A semiconductor memory device comprising a plurality of memory cells, each of which comprises:
an MOS transistor including a source region, a drain region and a channel region;
an active region (2-8) including said source region, said drain region and said channel region of said MOS transistor, said active region being formed in the surface portion of a semiconductor substrate (19);
an isolation region (29) formed in the surface portion of said semiconductor substrate, said isolation region surrounding said active region, thereby forming a boundary between said isolation region and said active region;
a gate electrode (9) formed on the substrate for the MOS transistor in the active region so as to divide the active region into a source-side active region (14, 16) with a storage contact (17, 19) and a drain-side active region (15) with a bit contact (18), the portion of said active region which is positioned under the gate electrode (9) functioning as said channel region of the MOS transistor;
a first impurity-implanted region (20, 22) formed in a part of said source-side active region (14, 16) so as to overlap with at least one part of said storage contact (17, 19) and the gate electrode (9), a portion of the source-side active region (14, 16) which overlaps with the first impurity-implanted region (20, 22) functioning as said source region of the MOS transistor; and
a second impurity-implanted region (11) formed in a part of said drain-side active region (15) so as to overlap with at least one part of said bit contact (18) and the gate electrode (9), a portion of the drain-side active region (15) which overlaps with the second impurity-implanted region (11) functioning as said drain region of the MOS transistor.

2. The semiconductor memory device according to claim 1, wherein the active regions (2-8) in said memory cells are disposed in columns parallel to the gate electrode (9), and the active regions in two adjacent columns are staggered to each other so that all the distances between adjacent active regions are approximately equal to each other.

3. The semiconductor memory device according to claim 2, wherein said active region (2-8) is T-shaped (Figs. 2, 3).

4. The semiconductor memory device according to claim 2, wherein said active region (32-35) is Y-shaped (Fig. 4).

5. The semiconductor memory device according to claim 1, wherein said active region (41) is V-Shaped (Fig. 7).

6. The semiconductor memory device according to claim 1, wherein said active region (101) is set diagonally across the gate electrode (102).

## Patentansprüche

1. Halbleiterspeichervorrichtung, die eine Vielzahl von Speicherzellen hat, von denen jede aufweist:
einen MOS-Transistor, der einen Sourcebereich, einen Drainbereich und einen Kanalbereich enthält;
einen aktiven Bereich (2-8), der den Sourcebereich, den Drainbereich und den Kanalbereich des genannten MOS-Transistors enthält und der im Oberflächenabschnitt eines Halbleitersubstrats (19) gebildet ist;
einen Isolierbereich (29), der im Oberflächenabschnitt des Halbleitersubstrats gebildet ist und der den aktiven Bereich umgibt, wodurch eine Grenze zwischen dem Isolierbereich und dem aktiven Bereich gebildet ist;
eine Gate-Elektrode (9), die auf dem Substrat für den MOS-Transistor in dem aktiven Bereich so gebildet ist, daß sie den aktiven Bereich in einen sourceseitigen aktiven Bereich (14, 16) mit einem Speicherkontakt (17, 19) und einen drainseitigen aktiven Bereich (15) mit einem Bitkontakt (18) teilt, wobei der Abschnitt des aktiven Bereichs, der unter der Gate-Elektrode (9) liegt, als Kanalbereich des MOS-Transistors funktioniert;
einen ersten Fremdstoffimplatationsbereich (20, 22), der in einem Teil des sourceseitigen aktiven Bereichs (14, 16) so gebildet ist, daß er sich mit wenigstens einem Teil des Speicherkontakts (17, 19) und der Gate-Elektrode (9) überlappt, wobei ein Teil des sourceseitigen aktiven Bereichs (14, 16), der sich mit dem Fremdstoffimplatationsbereich (20, 22) überlappt, als Sourcebereich des MOS-Transistors fungiert; und
einen zweiten Fremdstoffimplatationsbereich (11), der in einem Teil des drainseitigen aktiven Bereichs (15) so gebildet ist, daß er sich mit wenigstens einem Teil des Bitkontakts (18) und der Gate-Elektrode (9) überlappt, wobei ein Teil des drainseitigen aktiven Bereichs (15), der sich mit dem zweiten Fremdstoffimplatationsbereich (11) überlappt, als der Drainbereich des MOS-Transistors fungiert.

2. Halbleiterspeichervorrichtung nach Anspruch 1, bei der die aktiven Bereiche (2-8) in den Speicherzellen in Spalten parallel zur Gate-Elektrode (9) liegen, und die aktiven Bereiche in zwei benachbarten Spalten gegeneinander so gestaffelt sind, daß alle Distanzen zwischen benachbarten aktiven Bereichen ungefähr gleich sind.

3. Halbleiterspeichervorrichtung nach Anspruch 2, bei der der aktive Bereich (2-8) T-förmig ist (Figuren 2, 3).

4. Halbleiterspeichervorrichtung nach Anspruch 2, bei der der aktive Bereich (32-35) Y-förmig ist (Fig. 4).

5. Halbleiterspeichervorrichtung nach Anspruch 1, bei der der aktive Bereich (41) V-förmig ist (Fig. 7).

6. Halbleiterspeichervorrichtung nach Anspruch 1, bei der der aktive Bereich (101) diagonal quer über die Gate-Elektrode (102) gesetzt ist.

## Revendications

1. Dispositif de mémoire à semi-conducteur comprenant plusieurs cellules de mémoire, chacune comprenant :
un transistor MOS ayant une zone de source, une zone de drain et une zone de canal ;
une zone active (2-8), comprenant ladite zone de source, ladite zone de drain et ladite zone de canal dudit transistor MOS, ladite zone active étant formée dans la partie surface d'un substrat en semi-conducteur (19) ;
une zone isolante (29), formée dans la partie surface dudit substrat en semi-conducteur, ladite zone isolante entourant ladite zone active, pour ainsi former une interface entre ladite zone isolante et ladite zone active ;
une électrode de grille (9), formée sur le substrat pour le transistor MOS, dans la zone active de manière à diviser la zone active en une zone active côté source (14, 16), ayant un contact de mémorisation (17, 19), et en une zone active côté drain (15), ayant un contact de bits (18), la partie de ladite zone active située sous l'électrode de grille (9) fonctionnant en tant que ladite zone de canal du transistor MOS ;
une première zone à implantation d'impuretés (20, 22), formée dans une partie de ladite zone active côté source (14, 16), de manière à être à chevauchement avec au moins une partie dudit contact de mémorisation (17, 19) et l'électrode de grille (9), une partie de la zone active côté source (14, 16), à chevauchement avec la première zone à implantation d'impuretés (20, 22), fonctionnant en tant que ladite zone de source du transistor MOS ; et
une seconde zone à implantation d'impuretés (11), formée dans une partie de ladite zone active côté drain (15), de manière à recouvrir au moins une partie dudit contact de bits (18) et l'électrode de grille (9), une partie de la zone active côté drain (15), à chevauchement avec la seconde zone à implantation d'impuretés (11), fonctionnant en tant que ladite zone de drain du transistor MOS.

2. Dispositif de mémoire à semi-conducteur selon la revendication 1, dans lequel les zones actives (2-8) dans lesdites cellules de mémoire sont disposées en colonnes parallèles à l'électrode de grille (9), les zones actives de deux colonnes adjacentes étant décalées les unes par rapport aux autres de telle manière que les distances entre zones actives adjacentes soient approximativement égales les unes aux autres.

3. Dispositif de mémoire à semi-conducteur selon la revendication 2, dans lequel ladite zone active (2-8) est en forme de T (figures 2, 3).

4. Dispositif de mémoire à semi-conducteur selon la revendication 2, dans lequel ladite zone active (32-35) est en forme de Y (figure 4).

5. Dispositif de mémoire à semi-conducteur selon la revendication 1, dans lequel ladite zone active (41) est en forme de V (figure 7).

6. Dispositif de mémoire à semi-conducteur selon la revendication 1, dans lequel ladite zone active (101) est placée diagonalement, en travers de l'électrode de grille (102).
